# EUROPEAN PATENT APPLICATION

(11) **EP 4 528 427 A1**
(43) Date of publication of application: **26.03.2025**
(21) Application number: 23829951.5
(22) Date of filing: 14.06.2023
(51) Int. Cl.: G06F 1/20

(54) **COMPUTER SYSTEM AND SERVER**

(30) Priority: 27.06.2022 CN 202210742690; 22.07.2022 CN 202210869176
(71) Applicant: Huawei Technologies Co., Ltd., Shenzhen, Guangdong 518129 (CN)
(72) Inventor: XU, Weiqiang, Shenzhen, Guangdong 518129 (CN); WU, Biao, Shenzhen, Guangdong 518129 (CN); SUN, Si, Shenzhen, Guangdong 518129 (CN); LIN, Hui, Shenzhen, Guangdong 518129 (CN); LIU, Zhiquan, Shenzhen, Guangdong 518129 (CN)
(74) Representative: Pfenning, Meinig & Partner mbB
(86) International application number: PCT/CN2023/100071
(87) International publication number: WO 2024/001769

(57) **Abstract**

A computer system (100) and a server are provided, to improve heat dissipation of the computer system (100) and improve deployment space utilization of processors (201). The computer system (100) includes a heat dissipation layer (10), a computing layer (20), and a high-speed layer (30). The computing layer (20) includes a processor (201) configured to generate an electrical signal. The heat dissipation layer (10) includes a heat dissipation structure (101), the heat dissipation structure (101) is coupled to the processor (201), and the heat dissipation structure (101) is configured to dissipate heat for the processor (201). The high-speed layer (30) includes a cable module (301) configured to transmit the electrical signal, and the cable module (301) is coupled to the processor (201).

## Description

This application claims priority to Chinese Patent Application No. 202210742690.2, filed with the China National Intellectual Property Administration on June 27, 2022 and entitled "COMPUTER SYSTEM", which is incorporated herein by reference in its entirety.

This application claims priority to Chinese Patent Application No. 202210869176.5, filed with the China National Intellectual Property Administration on July 22, 2022 and entitled "COMPUTER SYSTEM AND SERVER", which is incorporated herein by reference in its entirety.

### TECHNICAL FIELD

This application relates to the field of computer technologies, and in particular, to a computer system and a server.

### BACKGROUND

With rapid development of computing-power-intensive application technologies such as artificial intelligence (artificial intelligence, AI) and high performance computing (high performance computing, HPC), a quantity of processors in a computer system is increasing. In addition, because computing power of the processor is continuously enhanced, power is also increased. This brings a great challenge to a heat dissipation capability of the computer system.

In a current computer system, a heat sink is usually separately deployed for each processor, and a heat exchange area of a single processor is limited. In addition, because signal cables need to be added to the computer system to implement communication connections between processors and between processors and other components, interference exists between the signal cables and heat sinks in limited entire space of the computer system. As a quantity of processors is increasing, a problem of a conflict between signal cable routing space and heat dissipation space becomes more serious. Due to limitations of a chassis size and a heat dissipation capability of the computer system, the existing computer system cannot meet a heat dissipation requirement of an increasing quantity of high-power processors. Therefore, how to provide a solution to meet a heat dissipation requirement of an increasing quantity of processors in a computer system with limited space becomes a technical problem to be urgently resolved.

### SUMMARY

This application provides a computer system and a server, to improve heat dissipation of the computer system and improve deployment space utilization of processors.

According to a first aspect, a computer system is provided. The computer system may be logically layered into the following three layers: a heat dissipation layer, a computing layer, and a high-speed layer. The computing layer has a processor configured to generate an electrical signal. The heat dissipation layer has a heat dissipation structure. The high-speed layer has a cable module configured to transmit the electrical signal. The heat dissipation structure is coupled to the processor. The cable module is coupled to the processor. In the computer system, the heat dissipation structure can dissipate heat for the processor, and the cable module can transmit the electrical signal.

The computer system is logically layered, the heat dissipation structure is coupled (which may also be referred to as coupled) to the processor, and the cable module is coupled to the processor, so that cable routing space in the cable module can be released, to resolve a problem of interference between cable routing space and heat dissipation, improve heat dissipation of the computer system, and improve deployment space utilization of processors.

In a possible implementation, the cable module includes an internal connection terminal, a cable, and an external connection terminal. The internal connection terminal is connected to the external connection terminal through the cable. The processor has an output terminal. The electrical signal generated by the processor is output by the output port. The internal connection terminal is coupled to the output terminal. The electrical signal is transmitted to the cable through the internal connection terminal, and then the cable outputs the electrical signal to the external connection terminal. The external connection terminal is coupled to a mainboard of the computer system.

The processor in the computing layer has the output terminal, the output terminal is configured to output the electrical signal generated by the processor, and the output terminal is coupled to the internal connection terminal in the cable module, so that the electrical signal is transmitted to the cable module through the internal connection terminal, the electrical signal is transmitted to the external connection terminal through the cable, and the electrical signal is output to the mainboard of the computer system through the external connection terminal.

In another possible implementation, the external connection terminal is detachably connected to a main body of the cable module. The main body of the cable module indicates a collection of components in the cable module other than the external connection terminal. For example, the internal connection terminal, the external connection terminal, and the cable may be considered as the main body of the cable module. The external connection terminal can be completely detached from the main body of the cable module, to be replaced with another external connection terminal based on a need of an actual application scenario. In addition, the external connection terminal includes a plurality of submodules, and each submodule is detachably connected to the main body of the cable module. For example, if the main body of the cable module includes a UBC terminal, each submodule is detachably connected to the UBC terminal. For example, a submodule of the external connection terminal can be detached from the main body of the cable module, to be replaced with another submodule. Therefore, adaptability of an external connection interface of the computer system can be improved. In this application, hardware does not need to be replaced, and only the cable module needs to be used to adapt to entire systems with different interfaces and sizes.

In another possible implementation, the external connection terminal is a blind mate connector. The blind mate connector is a specific implementation form of the external connection terminal. The blind mate connector is coupled to the mainboard of the computer system. For example, the blind mate connector is fastened to a PCB interface board of the computer system, and an interface of the mainboard is plugged to the PCB interface board. The blind mate connector can adjust the blind mate connector to a correct connection position based on a self-configured guide system, to facilitate connection between the high-speed layer and the mainboard of the computer system.

In another possible implementation, the heat dissipation structure includes a thermal pad, and the thermal pad is coupled to the processor (for example, the thermal pad is connected to the processor through the output terminal of the processor). The thermal pad is coupled to the processor, and the processor generates heat when outputting the electrical signal. The heat generated by the processor can be quickly conducted to the heat dissipation structure through the thermal pad, to perform cooling through the heat dissipation structure. For example, the thermal pad can cover an upper layer of a chip, the thermal pad can conduct heat to a cold plate, and the cold plate conducts heat through water cooling, so that heat dissipation processing on the processor can be implemented.

In another possible implementation, a quantity of thermal pads may be the same as a quantity of processors included in the computing layer. In the computer system, each time a thermal pad is disposed in the heat dissipation layer, a processor corresponding to the thermal pad is disposed in the computing layer. The computing layer includes a plurality of processors, and a corresponding thermal pad is disposed above each processor, so that heat dissipation efficiency of the processor can be improved.

In another possible implementation, the heat dissipation structure has a plurality of heat dissipation manners. For example, the heat dissipation structure uses any one, two, or three heat dissipation manners in air cooling, liquid cooling, and air assisted liquid cooling. The heat dissipation structure is deployed in the heat dissipation layer, and the computer system is logically layered, so that the heat dissipation structure can be separated from cable routing space. Therefore, the heat dissipation structure can improve heat dissipation efficiency of the processor in any one of various heat dissipation manners such as air cooling, liquid cooling, and air assisted liquid cooling.

In another possible implementation, the computing layer is located between the heat dissipation layer and the high-speed layer. The computer system is logically layered, so that the heat dissipation layer and the high-speed layer can be separately coupled to the computing layer. The computing layer is disposed between the heat dissipation layer and the high-speed layer, so that a problem of interference between heat dissipation and cable routing space is resolved. Spatial deployment positions of the heat dissipation layer and the high-speed layer are not limited in this application.

In another possible implementation, the heat dissipation layer is located at an upper layer of the computing layer, and the high-speed layer is located at a lower layer of the computing layer. The upper layer and the lower layer indicate relative positions. The following provides example descriptions by using an example in which the computer system sequentially includes the heat dissipation layer, the computing layer, and the high-speed layer from top to bottom. The computer system implemented in the logical layering manner is used, so that a problem of interference between heat dissipation and cable routing space is resolved, and space utilization of the computer system is improved.

In another possible implementation, the high-speed layer is located at an upper layer of the computing layer, and the heat dissipation layer is located at a lower layer of the computing layer. The upper layer and the lower layer indicate relative positions. The computer system sequentially includes the high-speed layer, the computing layer, and the heat dissipation layer from top to bottom. The computer system implemented in the logical layering manner is used, so that a problem of interference between heat dissipation and cable routing space is resolved, and space utilization of the computer system is improved.

According to a second aspect, this application further provides a server. The server includes the computer system according to any one of the first aspect or the implementations of the first aspect.

In the second aspect of this application, composition modules of the server can further implement the composition structures described in the first aspect and the various possible implementations. For details, refer to the descriptions in the first aspect and the various possible implementations.

It can be learned from the foregoing technical solutions that this application has the following advantages:

In this application, the computer system includes the heat dissipation layer, the computing layer, and the high-speed layer. The computing layer includes the processor configured to generate the electrical signal. The heat dissipation layer includes the heat dissipation structure, the heat dissipation structure is coupled to the processor, and the heat dissipation structure is configured to dissipate heat for the processor. The high-speed layer includes the cable module, the cable module is coupled to the processor, and the cable module is configured to transmit the electrical signal. In this application, the computer system is logically layered, the heat dissipation structure is coupled to the processor, and the cable module is coupled to the processor, so that cable routing space in the cable module can be released, to resolve a problem of interference between cable routing space and heat dissipation, improve heat dissipation of the computer system, and improve deployment space utilization of processors.

### BRIEF DESCRIPTION OF DRAWINGS

FIG. 1 is a diagram of a three-dimensional structure of a computer system according to this application;
FIG. 2 is a diagram of a logical structure of a computer system according to this application;
FIG. 3 is a side view of a high-speed layer according to this application;
FIG. 4 is a diagram of a three-dimensional structure of a high-speed layer according to this application;
FIG. 5 is a diagram of a plane of a high-speed layer according to this application;
FIG. 6 is a side view of a heat dissipation structure according to this application;
FIG. 7 is a diagram of a three-dimensional structure of a heat dissipation structure according to this application;
FIG. 8 is a diagram of a logical structure of a computer system according to this application;
FIG. 9 is a side view of a computing layer according to this application;
FIG. 10 is a diagram of a three-dimensional structure of a computing layer according to this application;
FIG. 11 is an exploded view of a computer system according to this application; and

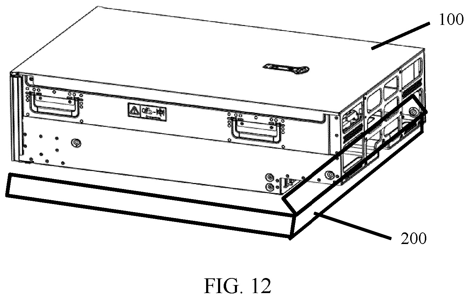

FIG. 12 is a diagram of a three-dimensional structure of a server according to this application.

Reference numerals in the accompanying drawings in this application are as follows:
computer system 100; mainboard 200; heat dissipation layer 10; and computing layer 20;
high-speed layer 30; heat dissipation structure 101; processor 201; and cable module 301;
internal connection terminal 3011; cable 3012; external connection terminal 3013; and thermal pad 1011;
pump 1012; main pipe 1013; branch pipe 1014; and air-liquid heat exchanger 1015; and
processor group 21; support 202; computing layer output terminal 203; and external connection submodule 30131.

### DESCRIPTION OF EMBODIMENTS

The following describes this application with reference to the accompanying drawings.

In the specification, claims, and accompanying drawings of this application, the terms "upper layer", "lower layer", and the like are intended to distinguish between relative relationships of similar objects in spatial positions, but do not necessarily indicate a specific order or sequence. It should be understood that the terms used in such a way are interchangeable in proper circumstances, and this is merely a distinguishing manner used when objects with a same attribute are described in this application. In addition, the terms "include", "have", and any other variants thereof are intended to cover non-exclusive inclusion, so that a process, method, system, product, or device that includes a series of units is not necessarily limited to those units, but may include other units that are not expressly listed or inherent to such a process, method, system, product, or device.

To resolve a technical problem of a heat dissipation requirement of an increasing quantity of processors in a computer system with limited space, this application provides a computer system. The computer system is divided into a heat dissipation layer, a computing layer, and a high-speed layer by using an architecture design idea of logical water and electricity layering. The heat dissipation layer including a heat dissipation structure and the high-speed layer including a cable module are respectively disposed on two sides of the computing layer including a processor. Therefore, vertical physical space in the entire computer system is fully utilized, an area of the heat dissipation structure is increased, and a heat dissipation requirement of an increasing quantity of processors can be met. In addition, because the cable module and the heat dissipation structure are distributed on the two sides of the computing layer, crosstalk between a signal cable and heat dissipation space is avoided.

The following describes, in detail with reference to the accompanying drawings, a computer system provided in this application.

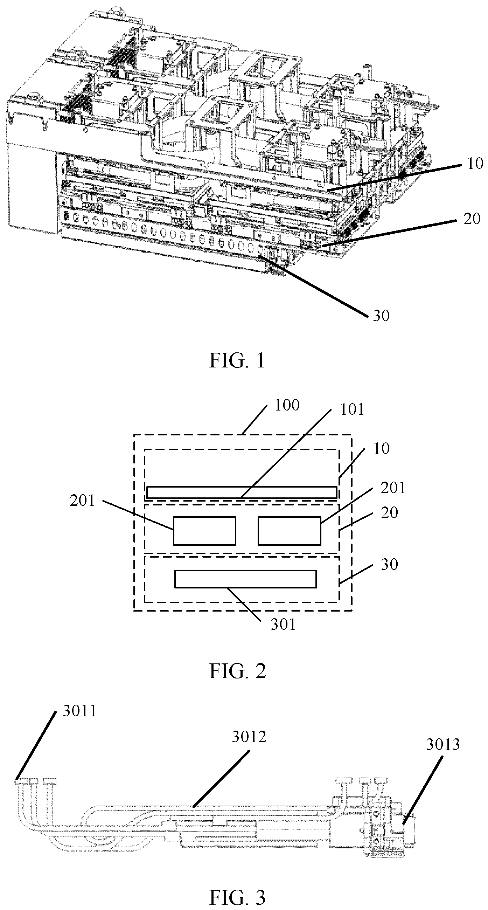

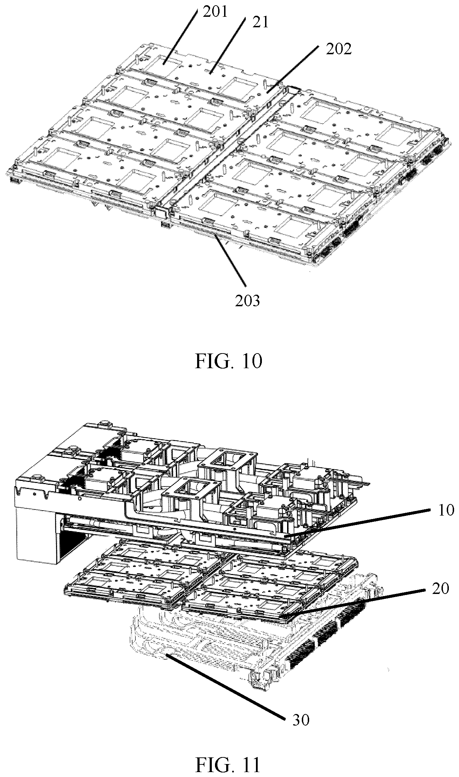

FIG. 1 is a diagram of a three-dimensional structure of a computer system according to this application, FIG. 2 is a diagram of a logical structure of a computer system, and FIG. 11 is an exploded view of a computer system according to this application. As shown in FIG. 1, FIG. 2, and FIG. 11, this application provides a computer system 100, including a heat dissipation layer 10, a computing layer 20, and a high-speed layer 30.

The computing layer 20 includes a processor 201 configured to generate an electrical signal. The processor 201 may be at least one of electronic components configured to perform data processing, such as a central processing unit (central processing unit, CPU), a graphics processing unit (graphics processing unit, GPU), a network process unit (network process unit, NPU), a neural network processing unit (neural network processing unit, NPU), or a data processing unit (data processing unit, DPU). For ease of description, the foregoing electronic component that performs data processing may also be referred to as an XPU.

It is worthwhile to note that the computer system 100 may include a plurality of processors 201, and the plurality of processors 201 may be of a same type or different types. A quantity and types of processors 201 do not constitute a limitation on this application. For ease of description, in the following descriptions of this application, a manner of connecting one processor 201 in the computing layer 20 to the heat dissipation layer 10 and the high-speed layer 30 is used as an example for description.

The heat dissipation layer 10 includes a heat dissipation structure 101, the heat dissipation structure 101 is coupled to the processor 201, and the heat dissipation structure 101 is configured to dissipate heat for the processor 201. The heat dissipation structure 101 may be disposed on an upper layer, a lower layer, a side surface, or the like of the processor 201.

It is worthwhile to note that the computer system 100 may include one or more heat dissipation structures 101, and the plurality of heat dissipation structures 101 may dissipate heat in a same manner or different manners. A quantity and types of heat dissipation structures 101 do not constitute a limitation on this application. For ease of description, in the following descriptions of this application, a manner of connecting one heat dissipation structure 101 in the heat dissipation layer 10 to the computing layer 20 is used as an example for description. In addition, coupling includes direct or indirect connection between two main bodies.

The high-speed layer 30 may include a cable module 301 configured to transmit the electrical signal, and the cable module 301 is coupled to the processor 201.

In this application, logical water and electricity layering is performed on the computer system, to obtain the heat dissipation layer 10, the computing layer 20, and the high-speed layer 30. A manner of deploying the heat dissipation layer 10 and the high-speed layer 30 in internal space of a chassis of the computer system is not limited in this application.

In some embodiments of this application, as shown in FIG. 1 and FIG. 2, the computing layer 20 is located between the heat dissipation layer 10 and the high-speed layer 30.

The computer system is logically layered, so that the heat dissipation layer 10 and the high-speed layer 30 can be separately coupled to the computing layer 20. The computing layer 20 is disposed between the heat dissipation layer 10 and the high-speed layer 30, so that a problem of interference between heat dissipation and cable routing space can be resolved. Spatial deployment positions of the heat dissipation layer 10 and the high-speed layer 30 are not limited in this application.

In some embodiments of this application, as shown in FIG. 1 and FIG. 2, the heat dissipation layer 10 is located at an upper layer of the computing layer 20, and the high-speed layer 30 is located at a lower layer of the computing layer 20.

The upper layer and the lower layer indicate relative positions. In FIG. 2, example descriptions are provided by using an example in which the computer system sequentially includes the heat dissipation layer 10, the computing layer 20, and the high-speed layer 30 from top to bottom. The computer system implemented in the logical layering manner is used, so that a problem of interference between heat dissipation and cable routing space is resolved, and space utilization of the computer system is improved.

In some embodiments of this application, the high-speed layer 30 is located at an upper layer of the computing layer 20, and the heat dissipation layer 10 is located at a lower layer of the computing layer 20.

The upper layer and the lower layer indicate relative positions. The computer system sequentially includes the high-speed layer 30, the computing layer 20, and the heat dissipation layer 10 from top to bottom. The computer system implemented in the logical layering manner is used, so that a problem of interference between heat dissipation and cable routing space is resolved, and space utilization of the computer system is improved.

The following separately describes the heat dissipation layer 10, the computing layer 20, and the high-speed layer 30 in detail.
**1. Computing layer 20**

As shown in FIG. 2, the computing layer 20 includes the processor 201. The processor 201 is disposed in a mainboard (mainboard). The processor 201 can generate an electrical signal, and the processor 201 is coupled to the cable module 301 in the high-speed layer 30, so that the electrical signal can be transmitted to the high-speed layer 30. Heat is generated in a working process of the processor 201. Therefore, the processor 201 has a heat dissipation requirement. The processor 201 is coupled to the heat dissipation structure 101 in the heat dissipation layer 10, so that the heat generated by the processor 201 can be conducted to the heat dissipation layer 10. Simultaneously, the processor 201 further needs to communicate with another component (such as a memory or a network adapter) in the mainboard or another device outside the computer system. Therefore, the computing layer 20 is further connected to the high-speed layer 30.

It should be noted that a quantity of processors 201 included in the computing layer 20 in this application is not limited. In FIG. 2, for example, the computing layer 20 includes one processor 201. This is not intended to limit this application.

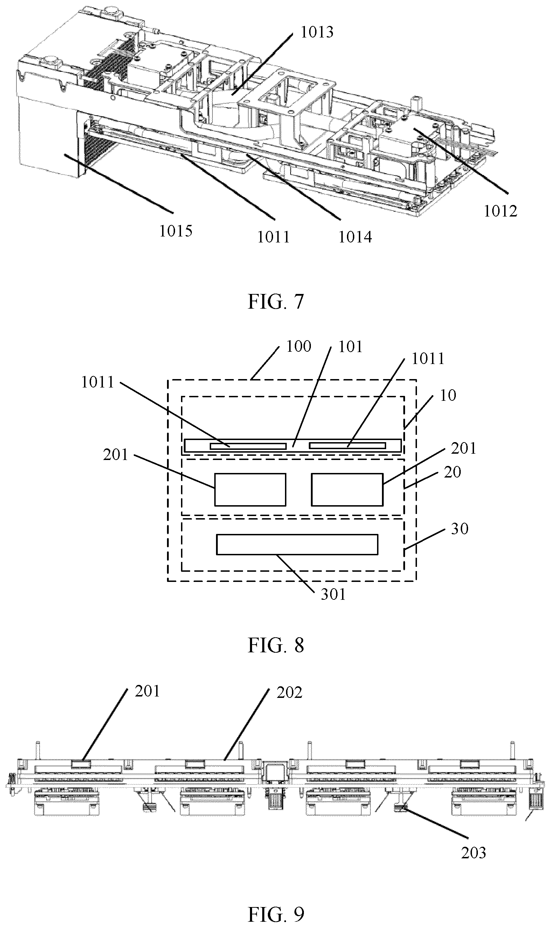

In some embodiments of this application, FIG. 9 is a side view of a computing layer according to this application, and FIG. 10 is a diagram of a three-dimensional structure of a computing layer according to this application. In FIG. 9 and FIG. 10, the computing layer is described from different perspectives. The following provides detailed descriptions by using FIG. 10 as an example.

Specifically, as shown in FIG. 10, the computing layer 20 includes a processor group 21.

The processor group includes at least two processors 201.

The processor group is coupled to the heat dissipation structure 101.

The processor group 21 shown in FIG. 10 may also be referred to as a chip module or a dual-XPU chip module. In FIG. 10, eight processor groups 21 are used as an example, and two processors 201 are disposed in each processor group 21.

Each processor group 21 has an output port 203, and the output port 203 is coupled to an internal connection terminal 3011 in the high-speed layer 30. For example, the output port 203 may be a UBC connector, and an electrical signal generated by the processor 201 is output to the high-speed layer 30 through the UBC connector.

In some embodiments of this application, the processor group 21 further includes a support 202.

The at least two processors 201 are fastened to the support 202.

The support 202 is coupled to the heat dissipation structure 101.

The support 202 plays a fastening role and a heat conduction role for the processor 201.

For example, the computing layer 20 is located at a middle layer of the computer system, and uses a design solution of a dual-XPU chip module. Two XPU management integrated circuits (integrated circuit, IC) in a single module share one UBC connector, to implement a design solution of a 16P XPU computer system.

### 2. High-speed layer 30

The high-speed layer 30 may also be referred to as a high-speed signal layer or a signal transmission layer. The high-speed layer 30 is configured to route a high-speed cable, and the high-speed layer 30 can transmit a high-speed electrical signal. As shown in FIG. 2, the high-speed layer 30 may include the cable module 301. The cable module 301 is coupled to the processor 201. The processor 201 can generate an electrical signal, and the processor 201 can transmit the electrical signal to the cable module 301.

It should be noted that, in this application, the high-speed layer 30 may include at least one cable module 301, and a quantity of cable modules 301 is not limited in this application. In FIG. 2, an example in which the high-speed layer 30 includes one cable module 301 is used, and this is not intended to limit embodiments of this application.

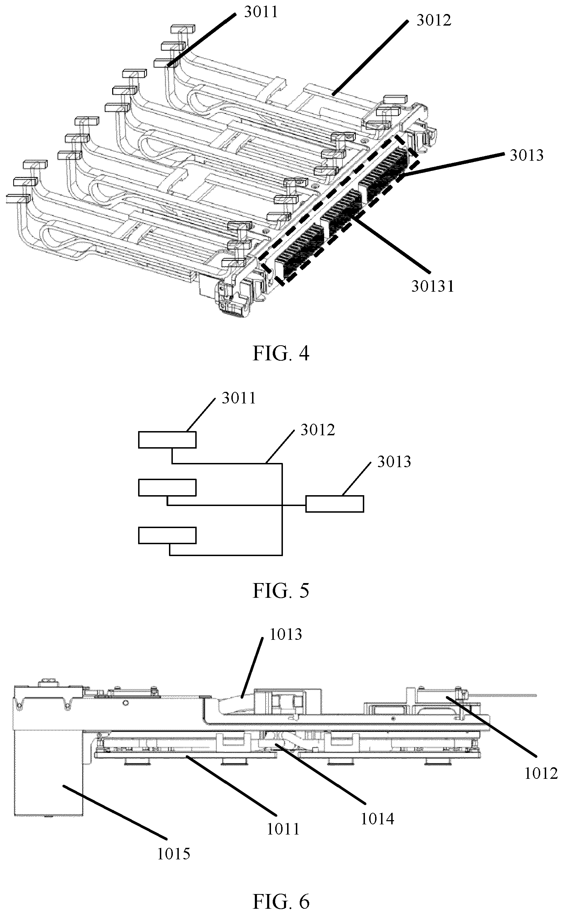

In some embodiments of this application, FIG. 3 is a side view of a high-speed layer according to this application, FIG. 4 is a diagram of a three-dimensional structure of a high-speed layer according to this application, and FIG. 5 is a diagram of a plane of a high-speed layer according to this application. In subsequent embodiments, a composition structure of the high-speed layer shown in FIG. 5 is used as an example for description.

As shown in FIG. 5, the cable module 301 includes the internal connection terminal 3011, a cable 3012, and an external connection terminal 3013. The internal connection terminal 3011 is connected to the external connection terminal 3013 through the cable. The internal connection terminal 3011 is configured to be coupled to an output terminal 203 of the processor 201. The external connection terminal 3013 is configured to be coupled to the mainboard of the computer system.

FIG. 9 is a side view of a computing layer. The processor 201 in the computing layer 20 has the output terminal 203. The output terminal 203 is configured to transmit an electrical signal generated by the processor 201. The output terminal 203 is coupled to the internal connection terminal 3011 in the cable module 301. For example, the internal connection terminal 3011 is plugged to the output terminal 203. For another example, the internal connection terminal 3011 is a male port, the output terminal is a female port, and the male port is plugged to the female port. The output terminal 203 is plugged to the internal connection terminal 3011, so that the electrical signal is transmitted to the cable module 301 through the internal connection terminal 3011, the electrical signal is transmitted to the external connection terminal 3013 through the cable 3012, and the electrical signal is output to the mainboard of the computer system through the external connection terminal 3013.

In this application, as shown in FIG. 5, one end of the cable 3012 is connected to the internal connection terminal 3011, and the other end of the cable 3012 is connected to the external connection terminal 3013. Shapes and quantities of internal connection terminals 3011, cables 3012, and external connection terminals 3013, and types of terminals are not limited.

In this application, the cable module 301 uses a flexible interface design manner, and uses high-speed cable routing. Compared with a solution in which cables are routed in a printed circuit board (printed circuit board, PCB) to connect different components and a repeater (Retimer) is used to enhance signal strength, in this application, the cable module 301 outside the PCB board is used to implement connection between components, thereby reducing a signal transmission delay caused by signal crosstalk in a signal transmission process. In addition, because there is no need to use a repeater to enhance an electrical signal, costs of the computer system are also reduced. A failure rate of using the repeater is 150 parts per million (parts per million, ppm) to 200 ppm, and a failure rate of using the cable module 301 in this application is 30 ppm to 50 ppm, so that a component failure rate is greatly reduced, thereby improving reliability of the computer system.

In this application, the internal connection terminal 3011 may also be referred to as an internal connection connector. For example, the internal connection terminal 3011 may be a unified bus connector (unified bus connector, UBC). Optionally, the internal connection terminal 3011 may be another type of connector. This is not limited herein.

The external connection terminal 3013 has a plurality of implementations. For example, the external connection terminal 3013 may be a connector that implements communication between the mainboard and the cable module, such as an SHLM connector, an SHDZ connector, or an SHDX connector, and is specifically determined with reference to an interface type of a mainboard that needs to be externally connected to the high-speed layer 30. The SHLM connector, the SHDZ connector, and the SHDX connector are respectively LM, DZ, and DX type connectors developed by Shanhu (SH).

As an example, the high-speed layer 30 is located at a bottom layer of the computer system. The cable module 301 includes the internal connection terminal 3011, the cable 3012, and the external connection terminal 3013. The internal connection terminal 3011 is specifically a UBC terminal. For example, the cable module 301 includes 24 UBC terminals, and the 24 UBC terminals are connected to the cable 3012. The external connection terminal 3013 is specifically an SHLM connector, and the SHLM connector may also be referred to as an external SHLM terminal. For example, the cable module 301 includes 14 SHLM connectors, and the SHLM connectors are connected to the cable 3012. The UBC terminal transmits a high-speed electrical signal to the SHLM connector through the cable 3012, and the SHLM connector transmits the high-speed electrical signal to the mainboard of the computer system.

It is worthwhile to note that, in the foregoing example, the external connection terminal 3013 may be replaced with a connector type other than the SHLM connector. For example, the external connection terminal 3013 may be specifically a UBC terminal, an SHDZ connector, or an SHDX connector, to meet requirements for adapting to different ecosystem interfaces.

It should be noted that, in this application, the external connection terminal 3013 may be replaced with another type of terminal to adapt to different interfaces, and the computing layer 20 is coupled to the mainboard of the computer system through the external connection terminal 3013. In addition, the external connection terminal 3013 is detachably connected to a main body part of the cable module 301. The main body part of the cable module 301 is used to indicate a part of the cable module 301 other than the external terminal. For example, as shown in FIG. 4, the main body of the cable module 301 includes the external connection terminal 3013, the internal connection terminal 3011, and the cable 3012. The external connection terminal 3013 is detachably connected to the main body part of the cable module 301, that is, the external connection terminal 3013 can be separated from the cable module 301, to replace a type of the external terminal 3013, to adapt to connection between the cable module 301 and a component or the mainboard. A dashed-line box in FIG. 4 shows the external connection terminal 3013, and a part other than the external connection terminal 3013 in FIG. 4 is the main body part of the cable module 301.

Further, in some embodiments of this application, as shown in FIG. 4, the cable 3012 is a detachable part, and the cable 3012 may be replaced with another cable type based on a need of an application scenario.

In some embodiments of this application, as shown in FIG. 4, the external connection terminal 3013 may further include one or more external connection submodules 30131. In FIG. 4, an example in which the external connection terminal 3013 includes three external connection submodules 30131 is used for description. The external connection submodule 30131 is detachably connected to the main body part of the cable module 301, that is, one or more external connection submodules 30131 can be separated from the cable module 301, to replace a type of the external connection submodule 30131, to adapt to connection between the cable module 301 and a component or the mainboard.

In some embodiments of this application, the external connection terminal 3013 is a blind mate connector.

The blind mate connector is a form of the external connection terminal 3013. The blind mate connector is configured to be coupled to the mainboard of the computer system. For example, the blind mate connector is fastened to a PCB interface board of the computer system, and an interface of the mainboard is plugged to the PCB interface board. The blind mate connector can adjust the blind mate connector to a correct connection position based on a self-configured guide system, to facilitate connection between the high-speed layer 30 and the mainboard of the computer system.

In some embodiments of this application, the external connection terminal 3013 is detachably connected to a main body of the cable module 301.

The external connection terminal 3013 is detachably connected to the main body of the cable module 301. The main body of the cable module 301 indicates a collection of components in the cable module 301 other than the external connection terminal 3013. The external connection terminal 3013 can be completely detached from the main body of the cable module 301, to be replaced with another external connection terminal 3013 based on a need of an actual application scenario. In addition, the external connection terminal 3013 includes a plurality of external connection submodules 30131. As shown in FIG. 4, each external connection submodule 30131 is detachably connected to the main body of the cable module 301. For example, if the main body of the cable module 301 includes a UBC terminal, every two external connection submodules 30131 are detachably connected to the UBC terminal. For example, a submodule 30131 of the external connection terminal 3013 can be detached from the main body of the cable module 301, to be replaced with another submodule 30131. Therefore, adaptability of an external connection interface of the computer system can be improved. In this application, hardware does not need to be replaced, and only the cable module 301 needs to be used to adapt to entire systems with different interfaces and sizes.

In addition, in this application, as shown in FIG. 5, the cable module 301 includes one or more cables 3012. The cable 3012 is further configured for connection between internal connection terminals 3011. For example, the internal connection terminal 3011 is specifically a UBC terminal, and UBC terminals in a same group can be connected through the cable 3012. Compared with a current solution of using a retimer, transmitting the electrical signal through the cable 3012 has advantages of being able to transmit a high-speed signal and a small signal loss.

### 3. Heat dissipation layer 10

The following describes the heat dissipation layer 10 provided in this application. As shown in FIG. 2, the heat dissipation layer 10 includes the heat dissipation structure. The heat dissipation structure is coupled to the processor 201 in the computing layer 20. Heat is generated in a working process of the processor 201. Therefore, the processor 201 has a heat dissipation requirement. The processor 201 is coupled to the heat dissipation structure 101 in the heat dissipation layer 10, so that the heat generated by the processor 201 can be conducted to the heat dissipation layer 10.

A heat dissipation manner of the heat dissipation structure 101 includes at least one of air cooling, liquid cooling, and liquid assisted air cooling (Liquid Assisted Air Cooling, LAAC).

In this application, the heat dissipation layer 10 is a separate layer in the computer system, and the heat dissipation layer 10 may be disposed on a board of the computing layer 20, so that the heat dissipation layer 10 can dissipate heat generated by the processor 201. A heat dissipation manner of the heat dissipation layer 10 is not limited in this application.

Air assisted liquid cooling may also be referred to as liquid assisted air cooling (liquid assisted air cooling, LAAC). LAAC may be used in a high performance computer system to dissipate heat for a processor 201 in a computing layer 20 in the computer system. In this application, the heat dissipation structure 101 is deployed in the heat dissipation layer 10, and the computer system is logically layered, so that the heat dissipation structure 101 can be separated from cable routing space. Therefore, the heat dissipation structure 101 can improve heat dissipation efficiency of the processor 201 in any one of various heat dissipation manners such as air cooling, liquid cooling, and air assisted liquid cooling.

In some embodiments of this application, FIG. 6 is a side view of a heat dissipation structure according to this application, FIG. 7 is a diagram of a three-dimensional structure of a heat dissipation structure according to this application, and FIG. 8 is a diagram of a logical structure of a computer system according to this application. In FIG. 6 to FIG. 8, the heat dissipation structure is described from different perspectives. The following uses FIG. 8 as an example for detailed description.

Specifically, the heat dissipation structure 101 includes a thermal pad 1011, and the thermal pad 1011 is coupled to the processor 201.

The thermal pad 1011 is coupled to the processor 201, so that heat generated by the processor 201 can be quickly conducted to the heat dissipation structure 101, to perform cooling through the heat dissipation structure 101. For example, when the heat dissipation structure 101 uses air assisted liquid cooling, thermal pads 1011 may cover chips one by one. In this case, the thermal pad 1011 can conduct heat to a cold plate. A liquid medium that can conduct heat is disposed in the cold plate. For example, heat generated by the processor 201 is conducted through water, so that heat dissipation processing on the processor 201 can be implemented. A shape and a material parameter of the thermal pad 1011 are not limited in this application.

In some embodiments of this application, as shown in FIG. 8, a quantity of thermal pads 1011 is the same as the quantity of processors 201 included in the computing layer 20, and thermal pads 1011 are in one-to-one correspondence with processors 201.

In FIG. 8, an example in which the computing layer 20 includes two processors 201 is used. In this case, a corresponding thermal pad 1011 is disposed above each processor 201, so that heat dissipation efficiency of the processor 201 can be improved.

In some embodiments of this application, as shown in FIG. 7, when the heat dissipation structure 101 uses air assisted liquid cooling, the heat dissipation structure 101 further includes a thermal pad 1011 and a heat exchanger. The thermal pad 1011 conducts heat to a cold plate, and the heat exchanger is configured to conduct heat of the cold plate, to transmit the heat of the processor 201 to the outside of the computer system.

As shown in FIG. 7, when the heat dissipation structure 101 uses air assisted liquid cooling, the heat dissipation structure 101 includes an air-liquid heat exchanger 1015, a main pipe 1013, a branch pipe 1014, and a pump 1012. The main pipe 1013 and the branch pipe 1014 are respectively arranged at an upper part and a lower part in the heat dissipation layer 10, and both the main pipe 1013 and the branch pipe 1014 are configured to connect the air-liquid heat exchanger 1015 and the pump 1012.

Both the main pipe 1013 and the branch pipe 1014 are water pipes, and the water pipes are cooling parts in the heat dissipation layer 10. When the quantity of processors 201 in the computing layer 20 increases, a quantity of water pipes increases. For example, the branch pipe 1014 is connected to the main pipe 1013, and the main pipe 1013 is connected to the pump 1012 (the pump 1012 is disposed in the chassis), to form a liquid loop. The air-liquid heat exchanger 1015 may also be referred to as an air-cooled heat exchanger, and has advantages of centralized heat dissipation, a compact structure, noise reduction, and energy efficiency improvement.

For example, the heat dissipation layer 10 is located at a top layer of the computer system, and uses an LAAC technology to eliminate impact of multi-chip cascading, thereby increasing a heat exchange area of the computer system. In addition, cable routing space is decoupled from heat dissipation space in a system structure, so that the heat dissipation layer 10 can support arrangement of more water pipes, thereby improving a heat dissipation capability of the system.

It can be learned from the example descriptions of the foregoing embodiments that, the computer system includes the heat dissipation layer 10, the computing layer 20, and the high-speed layer 30. The computing layer 20 includes the processor 201 configured to generate the electrical signal. The heat dissipation layer 10 includes the heat dissipation structure 101, the heat dissipation structure 101 is coupled to the processor 201, and the heat dissipation structure 101 is configured to dissipate heat for the processor 201. The high-speed layer 30 includes the cable module 301, the cable module 301 is coupled to the processor 201, and the cable module 301 is configured to transmit the electrical signal. In this application, the computer system is logically layered, the heat dissipation structure 101 is coupled to the processor 201, and the cable module 301 is coupled to the processor 201, so that cable routing space in the cable module 301 can be released, to resolve a problem of interference between cable routing space and heat dissipation, improve heat dissipation of the computer system, and improve deployment space utilization of processors 201.

The following describes a server provided in this application. As shown in FIG. 11, the server includes a mainboard and the computer system according to any one of FIG. 1 to FIG. 10.

The computer system provided in this application uses a system architecture design of logical water and electricity layering, and uses a flexible interface adaptation design, to implement flexible configuration of a plurality of processors by using a layered system design. In addition, in this application, the cable module 301 is used to implement the flexible interface adaptation design.

For example, in this application, in an LAAC technology, the computer system uses a multi-layer system architecture design, to divide height space into the heat dissipation layer 10, the computing layer 20, and the high-speed layer 30. Through spatial logical layering, chassis height and depth space of the computer system are fully utilized, to double a quantity of deployed processors. Computing power of the computer system is improved by 100%. Based on a quantity of processors, processors are designed based on an architecture of eight processors (which may also be referred to as 8P) in the industry. In this application, the quantity of processors in the computer system is doubled, and computing power is doubled, thereby improving heat dissipation of the computer system and improving deployment space utilization of processors.

It should be noted that, because content such as connection manners between modules/units in the server is based on a same concept as that in the computer system provided in this application, technical effects brought by the content are the same as those in the foregoing embodiments of this application. For specific content, refer to the descriptions in the foregoing embodiments of this application. Details are not described herein again.

In addition, it should be noted that the described apparatus embodiments are merely examples. The units described as separate parts may or may not be physically separate, and parts displayed as units may or may not be physical units, that is, may be located at one position, or may be distributed on a plurality of units. Some or all of the modules may be selected based on actual needs to achieve the objectives of the solutions of embodiments. In addition, in the accompanying drawings of the apparatus embodiments provided in this application, connection relationships between modules indicate that the modules have communication connections with each other, and may be specifically implemented as one or more buses or signal cables.

Based on the descriptions of the foregoing implementations, a person skilled in the art may clearly understand that this application may be implemented by using necessary universal hardware, or certainly may be implemented by using dedicated hardware, including a dedicated integrated circuit, a dedicated CPU, a dedicated memory, a dedicated component, and the like. All or some of the foregoing embodiments may be implemented by using hardware, firmware, or any combination thereof.

## Claims

1. A computer system, wherein the computer system comprises a heat dissipation layer, a computing layer, and a high-speed layer, wherein
the computing layer comprises a processor configured to generate an electrical signal;
the heat dissipation layer comprises a heat dissipation structure, the heat dissipation structure is coupled to the processor, and the heat dissipation structure is configured to dissipate heat for the processor; and
the high-speed layer comprises a cable module configured to transmit the electrical signal, and the cable module is coupled to the processor.

2. The computer system according to claim 1, wherein the cable module comprises an internal connection terminal, a cable, and an external connection terminal, the internal connection terminal is connected to the external connection terminal through the cable, the internal connection terminal is configured to be coupled to an output terminal of the processor, and the external connection terminal is configured to be coupled to a mainboard of the computer system.

3. The computer system according to claim 2, wherein the external connection terminal is detachably connected to a main body of the cable module.

4. The computer system according to claim 3, wherein the external connection terminal is a blind mate connector.

5. The computer system according to any one of claims 1 to 4, wherein the heat dissipation structure comprises a thermal pad, and the thermal pad is coupled to the processor.

6. The computer system according to claim 5, wherein a quantity of thermal pads is the same as a quantity of processors comprised in the computing layer, and thermal pads are in one-to-one correspondence with processors.

7. The computer system according to claim 5, wherein the heat dissipation structure uses at least one heat dissipation manner in air cooling, liquid cooling, and air assisted liquid cooling.

8. The computer system according to any one of claims 1 to 7, wherein the computing layer is located between the heat dissipation layer and the high-speed layer.

9. The computer system according to any one of claims 1 to 8, wherein the heat dissipation layer is located at an upper layer of the computing layer, and the high-speed layer is located at a lower layer of the computing layer.

10. The computer system according to any one of claims 1 to 8, wherein the high-speed layer is located at an upper layer of the computing layer, and the heat dissipation layer is located at a lower layer of the computing layer.

11. A server, wherein the server comprises the computer system according to any one of claims 1 to 10.
